# EUROPEAN PATENT APPLICATION

(11) **EP 2 574 688 A2**
(43) Date of publication of application: **03.04.2013**
(21) Application number: 11195486.3
(22) Date of filing: 23.12.2011
(51) Int. Cl.: C25D 17/06, C25D 17/00

(54) **Feeding belt for strip-shaped elements**

(30) Priority: 29.09.2011 KR 20110098863
(71) Applicant: Astjetec Co., Ltd., Incheon 403-858 (KR)
(72) Inventor: Chung, Jae Song, 157-734 Seoul (KR)
(74) Representative: Hano, Christian

(57) **Abstract**

Disclosed is a feeding belt for strip-shaped elements including a belt main body and fingers, wherein each of the fingers includes a mount part, a support fixing part, a coupling part, an angle displacement hinge part formed in the shape of a coil spring, and a gripping part fitted in a corresponding long hole of the belt main body, the angle displacement hinge part includes a spring portion directly connected to the support fixing part, a spring portion directly connected to the gripping part, and an intermediate spring portion between the spring portion directly connected to the support fixing part and the spring portion directly connected to the gripping part, and the diameter of the spring portion directly connected to the support fixing part is greater than that of the intermediate spring portion or the spring portion directly connected to the gripping part.

## Description

### BACKGROUND OF THE INVENTION

### Field of the Invention

The present invention relates to a feeding belt for strip-shaped elements, and more particularly to a feeding belt used to feed elements in a specific process, such as a plating process or a deflashing process, during production of semiconductors or other products.

### Description of the Related Art

A conventional feeding belt for strip-shaped elements is disclosed in U.S. Patent No. 7,128,817. As shown in FIGS. 1 to 3, a belt 1 is configured so that fingers 3 are detachably coupled to a belt main body 2. Each of the fingers 3 is configured so that a mount part 5 and a gripping part 6 are formed at opposite ends thereof, and an elastic hinge part 7 and a direction changing part 8 are provided between the mount part 5 and the gripping part 6. The elastic hinge part 7 and a direction changing part 8 are bent so as to be fitted into a corresponding mount hole 2a and a corresponding long hole 2b of the belt main body 2. Upon loading and unloading, the direction changing part 8 is pushed or released in the horizontal direction to open or close the gripping part 6. Consequently, the conventional feeding belt for strip-shaped elements has an advantage in that the construction of peripheral equipment is simplified. However, the conventional feeding belt for strip-shaped elements has the following problems.

First, in the elastic hinge part 7, which is formed in the shape of a coil spring, of each of the fingers 3, the direction changing part 8 is repeatedly pushed in the reverse direction in which the elastic hinge part 7 is unwound, not in the forward direction in which the elastic hinge part 7 is wound, upon loading and unloading of an element 4. As a result, fatigue is accumulated in the elastic hinge part 7 since the elastic hinge part 7 is formed of a wire exhibiting elasticity. Consequently, a fatigue fracture phenomenon occurs at the elastic hinge part 7 with the result that the lifespan of the elastic hinge part 7 is shortened.

Second, the direction changing part 8 of each of the fingers 3 merely serves to interconnect the elastic hinge part 7 and the gripping part 6 so that the elastic hinge part 7 and the gripping part 6 form a predetermined angle irrespective of whether the direction changing part 8 is formed in the shape of a spring or is simply bent since the direction changing part 8 is connected to the gripping part 6 from the mount part 5 via the elastic hinge part 7.

Third, the elastic hinge part 7 of each of the fingers 3 performs not only an elastic mounting function to couple the belt main body 2 and each of the fingers 3 in a supported state as the elastic hinge part 7 is mounted in the corresponding mount hole 2a of the belt main body 2 but also an elastic gripping function to generate grip force of the gripping part 6 as the angle of the gripping part 6 is changed about the center 7a of the elastic hinge part 7. That is, the elastic hinge part 7 is configured to exhibit functions or effects in a state in which the mounting function and the gripping function are simultaneously performed on a single position with the result that it is difficult to keep the balance between the elastic hinge part 7 and the belt main body, and therefore, it is not possible to achieve smooth operation.

### SUMMARY OF THE INVENTION

Therefore, the present invention has been made in view of the above problems. It is an object of the present invention to provide a feeding belt for strip-shaped elements wherein each angle displacement hinge part, which opens and closes a corresponding gripping part, includes a spring portion directly connected to a support fixing part, a spring portion directly connected to a gripping part, and an intermediate spring portion between the spring portion directly connected to the support fixing part and the spring portion directly connected to the gripping part, and each angle displacement hinge part is configured so that the diameter of the spring portion directly connected to the support fixing part is greater than that of the intermediate spring portion or the spring portion directly connected to the gripping part, thereby preventing the occurrence of a fatigue fracture phenomenon at each angle displacement hinge part during operation and preventing damage to each angle displacement hinge part due to friction between each angle displacement hinge part and a belt main body during operation and thus greatly increasing lifespan of fingers.

It is another object of the present invention to provide a feeding belt for strip-shaped elements wherein each support fixing part, by which a corresponding finger is elastically mounted to a belt main body when the finger is coupled to the belt main body, and each angle displacement hinge part to serve as a hinge, by which the angle of a gripping part of the finger is changed, and, in addition, to generate elastic gripping force to grip the gripping part are independently operated, and the gripping part is pushed by external force so that the gripping part is opened or closed in the forward direction in which each angle displacement hinge part is wound, not in the reverse direction in which each angle displacement hinge part is unwound, thereby achieving smooth and secure operation while exhibiting high durability.

In accordance with the present invention, the above and other objects can be accomplished by the provision of a feeding belt used to feed strip-shaped elements in an automated inline process, such as a plating process or a deflashing process, during mass production of semiconductors or other products, the feeding belt being configured so that a plurality of separately manufactured fingers is coupled to a belt main body in a predetermined pitch interval, wherein the belt main body includes mount holes, into which mount parts and support fixing parts of the respective fingers are coupled, and long holes provided below the respective mount holes so that gripping parts of the respective fingers are movably fitted in the long holes, each of the fingers includes a mount part provided at one end thereof, a support fixing part provided adjacent to the mount part, the support fixing part being configured so that a portion of the support fixing part is coupled into a corresponding one of the mount holes of the belt main body to elastically supporting the belt main body and each of the fingers, a coupling part provided between the mount part and the support fixing part so that the coupling part is fitted in a corresponding one of the mount holes of the belt main body, an angle displacement hinge part provided adjacent to the support fixing part to transmit elastic gripping force to a corresponding one of the gripping parts and to serve as a hinge, the angle displacement hinge part being formed in the shape of a coil spring, and a gripping part provided adjacent to the angle displacement hinge part, the gripping part being bent at the other end thereof, the gripping part being fitted in a corresponding one of the long holes of the belt main body, the mount part, the coupling part, the support fixing part, the angle displacement hinge part, and the gripping part being integrally connected to each other, the angle displacement hinge part includes a spring portion directly connected to the support fixing part, a spring portion directly connected to the gripping part, and an intermediate spring portion between the spring portion directly connected to the support fixing part and the spring portion directly connected to the gripping part, the spring portion directly connected to the support fixing part, the intermediate spring portion, and the spring portion directly connected to the gripping part being integrally connected to each other, and the diameter of the spring portion directly connected to the support fixing part is greater than that of the intermediate spring portion or the spring portion directly connected to the gripping part.

Also, the angle displacement hinge part may be configured so that the diameter of the intermediate spring portion is greater than that of the spring portion directly connected to the gripping part.

Also, the angle displacement hinge part of each of the fingers may be configured to have a concentric structure in which the center of the spring portion directly connected to the support fixing part, the center of the intermediate spring portion, and the center of the spring portion directly connected to the gripping part coincide with each other.

Also, the angle displacement hinge part of each of the fingers may be configured to have an eccentric structure in which the center of the spring portion directly connected to the support fixing part, the center of the intermediate spring portion, and the center of the spring portion directly connected to the gripping part do not coincide with each other.

Also, each of the fingers may be formed of a wire, the mount part, the support fixing part, the angle displacement hinge part, and the gripping part being integrally formed, the support fixing part may be formed in the shape of a bent coupling part, and the angle displacement hinge part may be formed in the shape of a coil spring.

Also, each of the fingers may be formed of a wire, the mount part, the support fixing part, the angle displacement hinge part, and the gripping part being integrally formed, and the support fixing part may be wound in the direction opposite to the direction in which the angle displacement hinge part is wound.

Also, the mount part, the support fixing part, the angle displacement hinge part, and the gripping part of each of the fingers may be integrally formed, and an additional bent part may be provided between the angle displacement hinge part and the gripping part.

In the feeding belt according to the present invention, therefore, each of the angle displacement hinge parts, which open and close the respective gripping parts, includes the spring portion directly connected to the support fixing part, the spring portion directly connected to the gripping part, and the intermediate spring portion between the spring portion directly connected to the support fixing part and the spring portion directly connected to the gripping part, and each of the angle displacement hinge parts is configured so that the diameter of the spring portion directly connected to the support fixing part is greater than that of the intermediate spring portion or the spring portion directly connected to the gripping part, or each of the angle displacement hinge parts is configured to have an eccentric structure in which the centers of the spring portions do not coincide with each other or is configured to have a concentric structure in which the centers of the spring portions coincide with each other. During operation, therefore, force is balanced and uniformly distributed by the action of the spring of each of the angle displacement hinge parts, thereby achieving smoother operation. Consequently, it is possible to prevent the occurrence of a fatigue fracture phenomenon and to prevent damage to the angle displacement hinge parts due to friction between the angle displacement hinge parts and the belt main body during operation, thereby greatly increasing lifespan of the fingers. Also, the support fixing parts, by which the fingers are elastically mounted to the belt main body when the fingers are coupled to the belt main body, and the angle displacement hinge parts to serve as hinges, by which angles of the gripping parts of the fingers are changed, and, in addition, to generate elastic gripping force to grip the gripping parts are independently operated. Also, the gripping parts are pushed by external force so that the gripping parts are opened or closed in the forward direction in which the spring of each of the angle displacement hinge parts is wound, not in the reverse direction in which the spring of each of the angle displacement hinge parts is unwound, thereby achieving smooth and secure operation while exhibiting high durability.

### BRIEF DESCRIPTION OF THE DRAWINGS

The above and other objects, features and other advantages of the present invention will be more clearly understood from the following detailed description taken in conjunction with the accompanying drawings, in which:

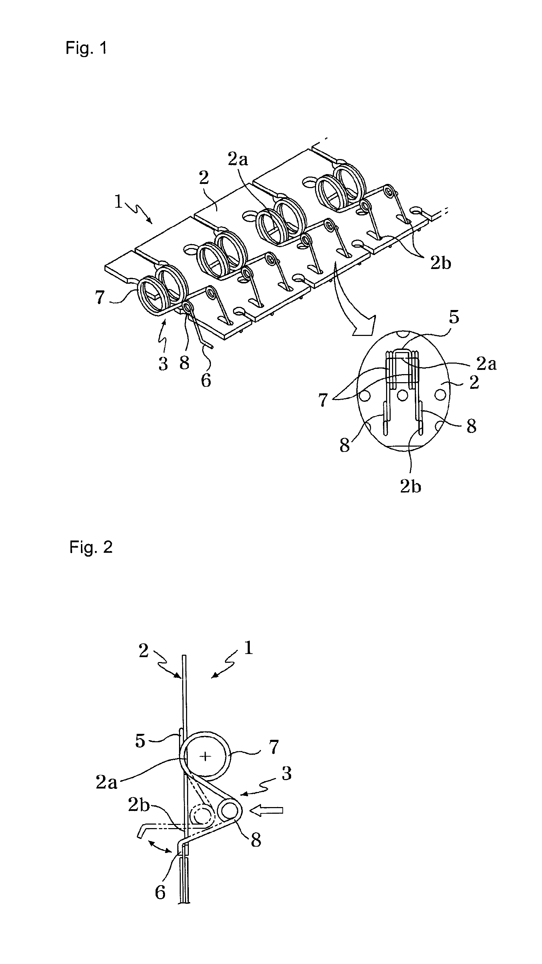

FIG. 1 is a perspective view, partially omitted, showing the external appearance of a conventional feeding belt for strip-shaped elements;
FIG. 2 is a side view of FIG. 1;
FIG. 3 is a side view showing another example of FIG. 2;
FIG. 4 is a perspective view, partially omitted, showing the external appearance of a feeding belt for strip-shaped elements according to an embodiment of the present invention;
FIG. 5 is a plan view of FIG. 4;
FIG. 6 is a side view, partially cutaway, of FIG. 5;
FIG. 7 is a plan view showing a feeding belt for strip-shaped elements according to another embodiment of the present invention;
FIG. 8 is a side view, partially cutaway, of FIG. 7;
FIG. 9 is a plan view showing a feeding belt for strip-shaped elements according to another embodiment of the present invention;
FIG. 10 is a side view, partially cutaway, of FIG. 9;
FIG. 11 is a plan view showing a feeding belt for strip-shaped elements according to another embodiment of the present invention;
FIG. 12 is a side view, partially cutaway, of FIG. 11;
FIG. 13 is a plan view showing a feeding belt for strip-shaped elements according to another embodiment of the present invention;
FIG. 14 is a side view, partially cutaway, of FIG. 13; and
FIG. 15 is a side view, partially cutaway, showing a feeding belt for strip-shaped elements according to yet another embodiment of the present invention.

### DETAILED DESCRIPTION OF THE INVENTION

Now, preferred embodiments of the present invention will be described in detail with reference to the accompanying drawings.

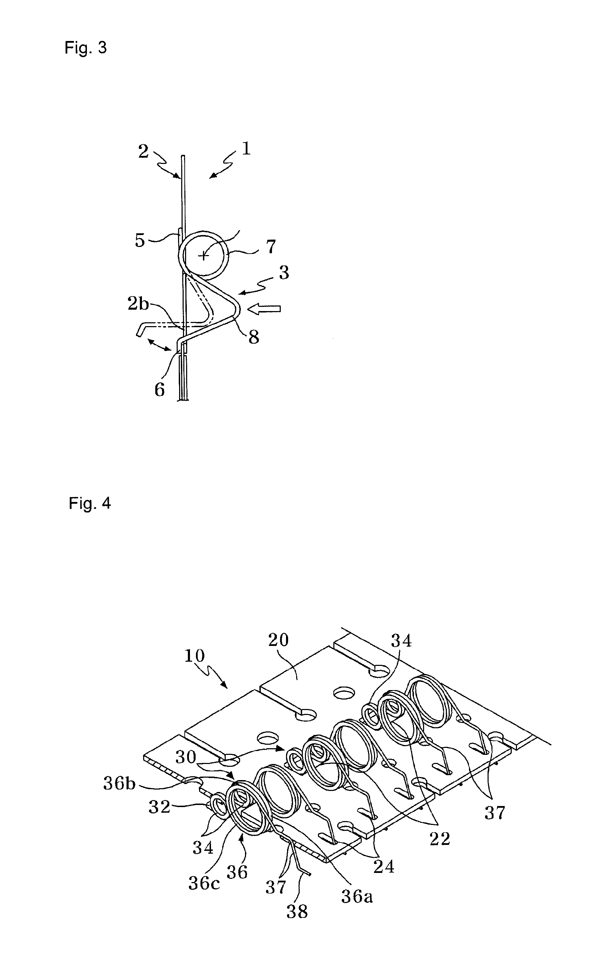

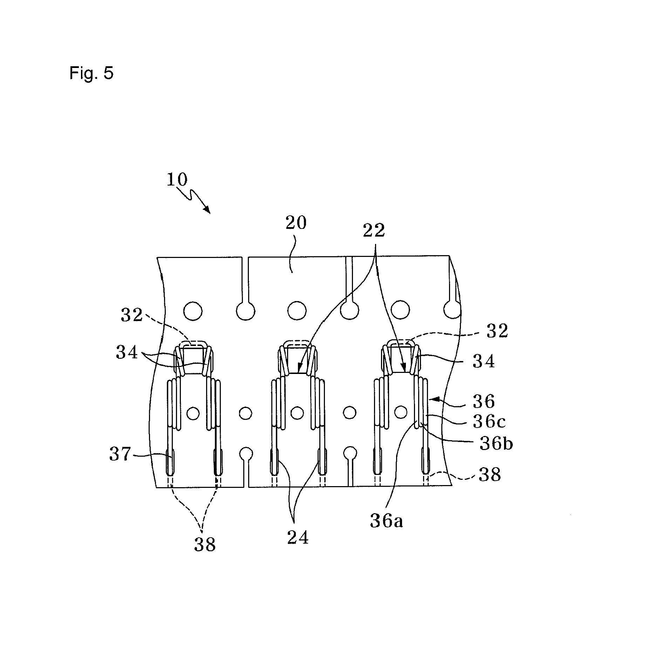

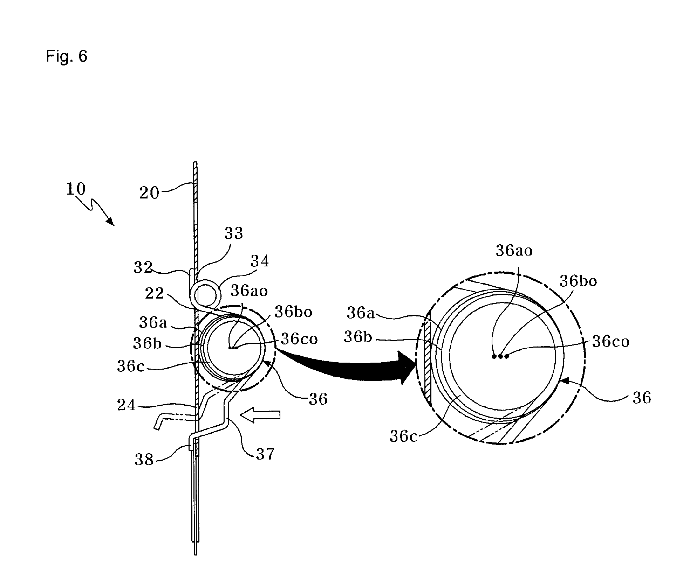

In common, various embodiments of the present invention as shown in FIGS. 4 to 15 provide a feeding belt used to feed strip-shaped elements in an automated inline process, such as a plating process or a deflashing process, during mass production of semiconductors or other products, the feeding belt being configured so that a plurality of separately manufactured fingers 30 is coupled to a belt main body 20 in a predetermined pitch interval, wherein the belt main body 20 includes mount holes 22, into which mount parts 32 and support fixing parts 34 of the respective fingers 30 are coupled, and long holes 24 provided below the respective mount holes 22 so that gripping parts 38 of the respective fingers 30 are movably fitted in the long holes 24, each of the fingers 30 includes a mount part 32 provided at one end thereof, a support fixing part 34 provided adjacent to the mount part 32, the support fixing part 34 being configured so that a portion of the support fixing part 34 is coupled into a corresponding one of the mount holes 22 of the belt main body 20 to elastically support the belt main body 20 and each of the fingers 30, a coupling part 33 provided between the mount part 32 and the support fixing part 34 so that the coupling part 33 is fitted in a corresponding one of the mount holes 22 of the belt main body 20, an angle displacement hinge part 36 provided adjacent to the support fixing part 34 to transmit elastic gripping force to a corresponding one of the gripping parts 38 and to serve as a hinge, the angle displacement hinge part 36 being formed in the shape of a coil spring, and a gripping part 38 provided adjacent to the angle displacement hinge part 36, the gripping part 38 being bent at the other end thereof, the gripping part 38 being fitted in a corresponding one of the long holes 24 of the belt main body 20, the mount part 32, the coupling part 33, the support fixing part 34, the angle displacement hinge part 36, and the gripping part 38 being integrally connected to each other, the angle displacement hinge part 36 includes a spring portion 36a directly connected to the support fixing part 34, a spring portion 36c directly connected to the gripping part 38, and an intermediate spring portion 36b between the spring portion 36a directly connected to the support fixing part 34 and the spring portion 36c directly connected to the gripping part 38, the spring portion 36a directly connected to the support fixing part 34, the intermediate spring portion 36b, and the spring portion 36c directly connected to the gripping part 38 being integrally connected to each other, and the diameter of the spring portion 36a directly connected to the support fixing part 34 is greater than that of the intermediate spring portion 36b or the spring portion 36c directly connected to the gripping part 38.

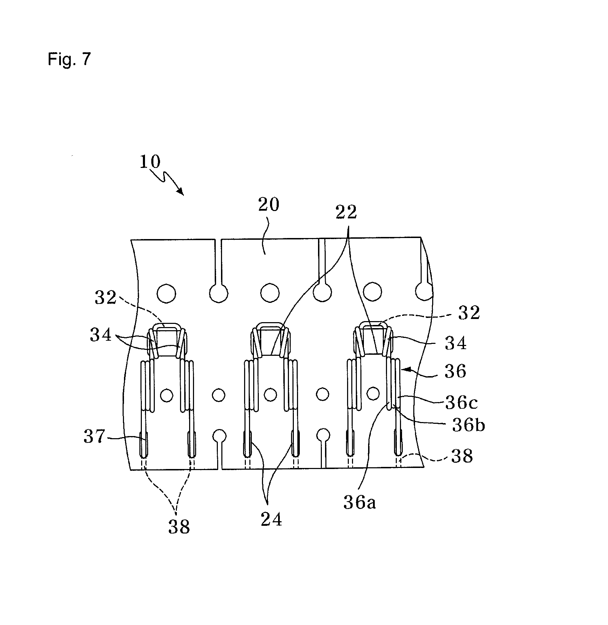

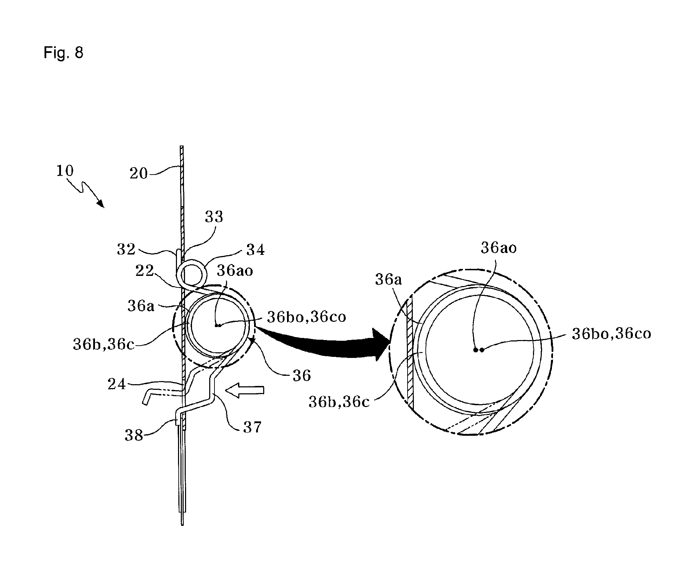

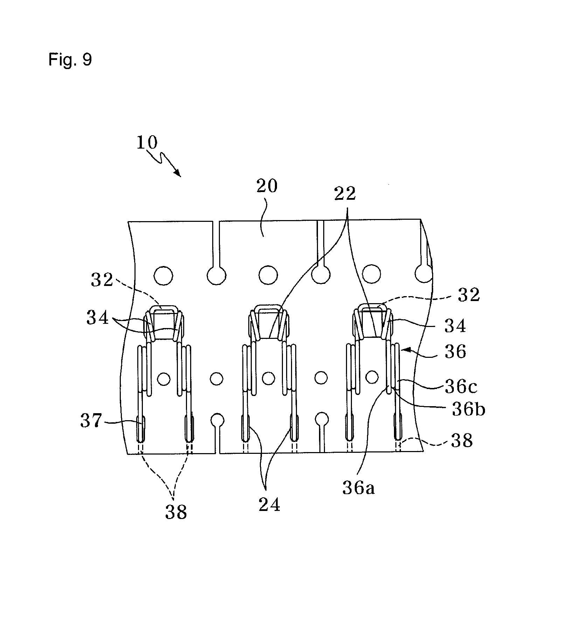

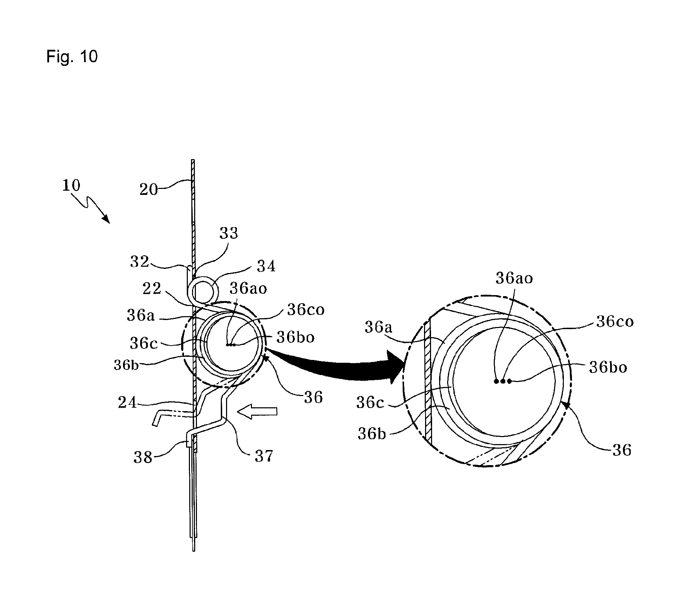

The angle displacement hinge part 36 may be configured so that the diameter of the intermediate spring portion 36b is greater than that of the spring portion 36c directly connected to the gripping part 38 as shown in FIGS. 4 to 6, so that the diameter of the intermediate spring portion 36b is equal to that of the spring portion 36c directly connected to the gripping part 38 as shown in FIGS. 7 and 8, or so that the diameter of the intermediate spring portion 36b is less than that of the spring portion 36c directly connected to the gripping part 38 as shown in FIGS. 9 and 10.

Also, the angle displacement hinge part 36 may be configured to have an eccentric structure in which the center 36ao of the spring portion 36a directly connected to the support fixing part 34, the center 36bo of the intermediate spring portion 36b, and the center 36co of the spring portion 36c directly connected to the gripping part 38 do not coincide with each other as shown in FIG. 4 to 6, 7, 8, 9 and 10. In this structure, the feeding belt is operated in a state in which the spring portion 36c directly connected to the gripping part 38, movable during operation of the feeding belt, and the intermediate spring portion 36b are not in direct contact with the belt main body 20, thereby preventing damage to the belt main body 20 or the fingers 30 due to friction therebetween.

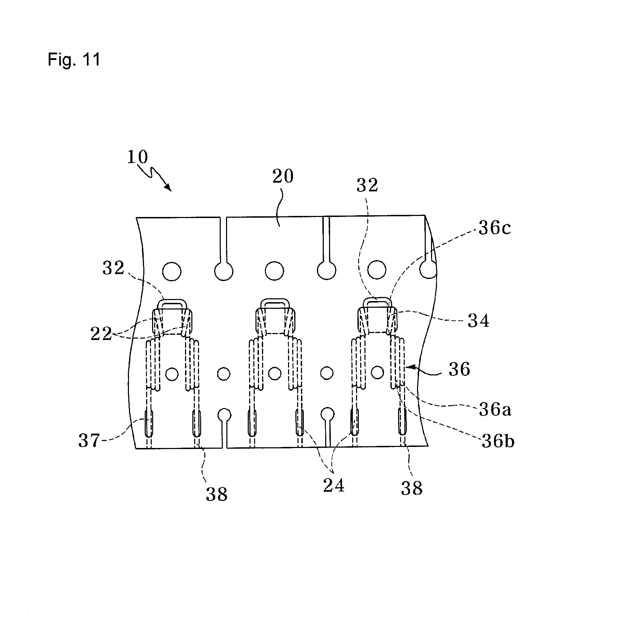

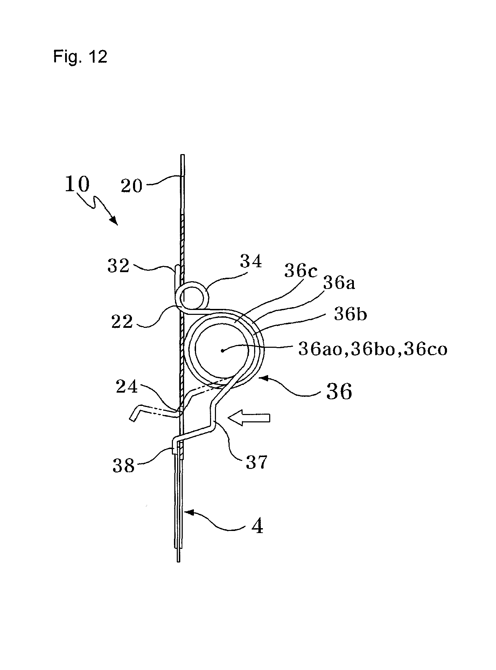

Alternatively, the angle displacement hinge part 36 may be configured to have a concentric structure in which the center 36ao of the spring portion 36a directly connected to the support fixing part 34, the center 36bo of the intermediate spring portion 36b, and the center 36co of the spring portion 36c directly connected to the gripping part 38 coincide with each other as shown in FIGS. 11 and 12. Even in this structure, the feeding belt is operated in a state in which the spring portion 36c directly connected to the gripping part 38, movable during operation of the feeding belt, and the intermediate spring portion 36b are not in direct contact with the belt main body 20, thereby preventing damage to the belt main body 20 or the fingers 30 due to friction therebetween.

Each of the fingers 30 may be formed of a wire, the mount part 32, the support fixing part 34, the angle displacement hinge part 36, and the gripping part 38 may be integrally formed, and the support fixing part 34 may be wound in the direction opposite to the direction in which the angle displacement hinge part 36 is wound, as shown in FIGS. 4 to 12.

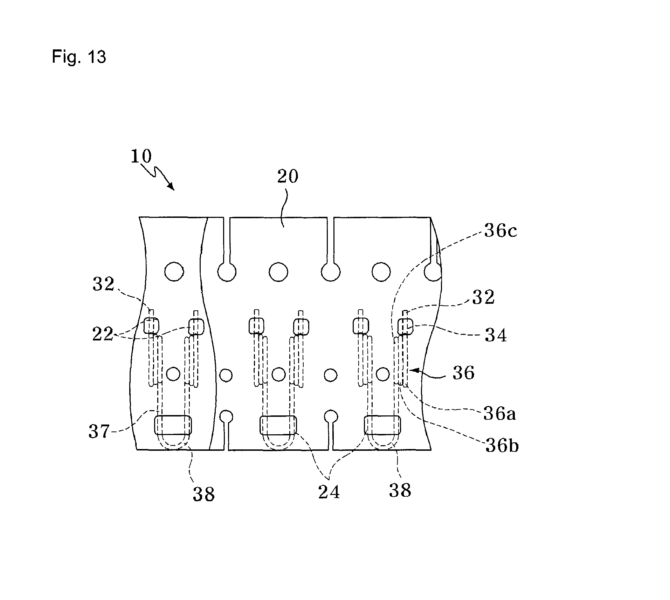

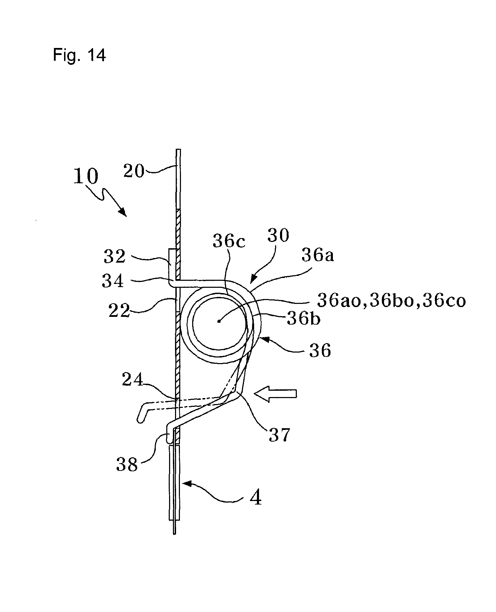

Also, each of the fingers 30 may be formed of a wire, the mount part 32, the support fixing part 34, the angle displacement hinge part 36, and the gripping part 38 may be integrally formed, the support fixing part 34 may be formed in the shape of a bent coupling part, and the angle displacement hinge part 36 may be formed in the shape of a coil spring, as shown in FIGS. 13 and 14.

Alternatively, the mount part 32, the support fixing part 34, the angle displacement hinge part 36, and the gripping part 38 of each of the fingers 30 may be integrally formed, and an additional bent part 37 may be provided between the angle displacement hinge part 36 and the gripping part 38 to easily perform a pushing operation in the horizontal direction, as shown in FIGS. 4 to 10, 13 and 14.

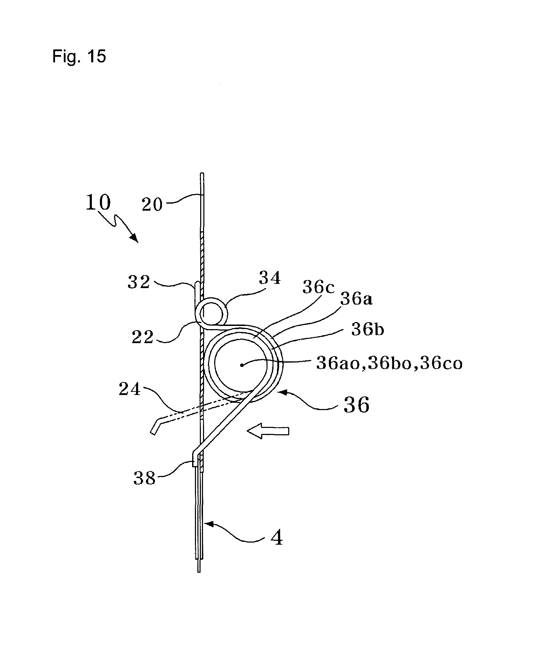

Of course, as shown in FIG. 15, the mount part 32, the support fixing part 34, the angle displacement hinge part 36, and the gripping part 38 of each of the fingers 30 may be integrally formed, and the additional bent part 37 may not be formed between the angle displacement hinge part 36 and the gripping part 38 so that the angle displacement hinge part 36 and the gripping part 38 are arranged in a straight line although such a horizontal pushing operation is not easily performed.

Hereinafter, the operation of the feeding belt with the above-stated construction according to the present invention will be described in detail.

The fingers 30 are coupled to the belt main body 20 to constitute a belt 10 as follows. First, the mount part 32 and a portion of the support fixing part 34 of each of the fingers 30 are coupled into a corresponding one of the mount holes 22 formed at the belt main body 20. The coupling part 33 provided between the mount part 32 and the support fixing part 34 of each of the fingers 30 is fitted into the upper part of a corresponding one of the mount holes 22. The gripping part 38 of each of the fingers 30 is fitted into a corresponding one of the long holes 24 formed below the respective mount holes 22 of the belt main body 22, thereby achieving coupling of the fingers 30 to the belt main body 20.

The fingers 30 are coupled into the respective mount holes 22 and long holes 24 of the belt main body 20 in a predetermined pitch interval to constitute the belt 10. The coupling parts 33 of the fingers 30 are securely fitted into the respective mount holes 22 of the belt main body 20, and the gripping parts 38 of the fingers 30 are caught by the lower parts of the respective long holes 24 with the result that the fingers 30 are coupled to the belt main body 20 in a state in which the fingers 30 are elastically supported by the belt main body 20. Consequently, coupling between the belt main body 20 and the fingers 30 in a state in which the fingers 30 are elastically supported by the belt main body 20 is achieved by the support fixing parts 34, each of which is formed in the shape of a coil spring, of the fingers 30, and elastic opening and closing of the gripping parts 38 of the fingers 30 about the respective hinge centers 36a is achieved by the angle displacement hinge parts 36, each of which is formed in the shape of a coil spring, of the fingers 30.

An element 4 is loaded as follows. When the fingers 30 are pushed in the horizontal direction indicated by arrows as shown in the drawings, a sufficient loading space is provided between the belt main body 20 and the gripping parts 38. When the element 4 is located in the loading space and the pushing operation of the fingers 30 is released in this state, the gripping parts 38 return to their original positions with the result that the element 4 is gripped between the belt main body 20 and the gripping parts 38.

In a process in which the fingers 30 are pushed to separate the gripping parts 38 from the belt main body 20 or in a process in which the pushing operation of the fingers 30 is released so that the gripping parts 38 return to their original positions to load the element 4, the fingers 30 are pushed in the horizontal direction or the pushing operation of the fingers 30 is released in the horizontal direction. Consequently, forcible downward movement of the element 4 does not occur, and therefore, it is possible to more securely load the element 4.

The element 4 is unloaded as follows. In order reverse to that of the loading process, separation of the gripping parts 38 from the belt main body 20 by pushing the fingers 30 in the horizontal direction, natural dropping of the element as the result of separation between the gripping parts 38 and the belt main body 20, and returning of the gripping parts 39 to their original positions by releasing the pushing operation of the fingers 30 are sequentially carried out.

Each of the angle displacement hinge parts 36, which open and close the respective gripping parts 38, includes the spring portion 36a directly connected to the support fixing part 34, the spring portion 36c directly connected to the gripping part 38, and the intermediate spring portion 36b between the spring portion 36a directly connected to the support fixing part 34 and the spring portion 36c directly connected to the gripping part 38. The spring portion 36a directly connected to the support fixing part 34, the intermediate spring portion 36b, and the spring portion 36c directly connected to the gripping part 38 are integrally connected to each other. The angle displacement hinge part 36 is configured so that the diameter of the spring portion 36a directly connected to the support fixing part 34 is greater than that of the intermediate spring portion 36b or the spring portion 36c directly connected to the gripping part 38, so that the diameter of the intermediate spring portion 36b is greater than that of the spring portion 36c directly connected to the gripping part 38, so that the diameter of the intermediate spring portion 36b is equal to that of the spring portion 36c directly connected to the gripping part 38, or so that the diameter of the intermediate spring portion 36b is less than that of the spring portion 36c directly connected to the gripping part 38. In this case, the diameter of the spring portion 36a directly connected to the support fixing part 34, which is most distant from the spring portion 36c directly connected to the gripping part 38, is the greatest with the result that the spring portion 36a directly connected to the support fixing part 34 comes into contact with the surface of the belt main body 20 when each of the fingers is mounted to the belt main body 20. However, the remaining portions of each of the angle displacement hinge parts 36, i.e. the intermediate spring portion 36b and the spring portion 36c directly connected to the gripping part 38, which is actually movable, do not come into contact with the belt main body 20 with the result that the opening and closing operation is freely achieved, force is balanced and uniformly distributed by the action of the spring, thereby achieving smooth operation, friction between the belt main body 20 and the spring portions 36b and 36c is prevented, thereby preventing damage to the spring portions 36b and 36c and thus greatly increasing lifespan of the fingers.

In particular, the angle displacement hinge part 36 of each of the fingers 30 is configured to have an eccentric structure in which the center 36ao of the spring portion 36a directly connected to the support fixing part 34, the center 36bo of the intermediate spring portion 36b, and the center 36co of the spring portion 36c directly connected to the gripping part 38 do not coincide with each other or is configured to have a concentric structure in which the center 36ao of the spring portion 36a directly connected to the support fixing part 34, the center 36bo of the intermediate spring portion 36b, and the center 36co of the spring portion 36c directly connected to the gripping part 38 coincide with each other. Even in this case, the diameter of the spring portion 36a directly connected to the support fixing part 34, which is most distant from the spring portion 36c directly connected to the gripping part 38, is the greatest with the result that the spring portion 36a directly connected to the support fixing part 34 comes into contact with the surface of the belt main body 20 when each of the fingers is mounted to the belt main body 20. However, the remaining portions of each of the angle displacement hinge parts 36, i.e. the intermediate spring portion 36b and the spring portion 36c directly connected to the gripping part 38, which is actually movable, do not come into contact with the belt main body 20 with the result that the opening and closing operation is freely achieved, force is balanced and uniformly distributed by the action of the spring, thereby achieving smooth operation, friction between the belt main body 20 and the spring portions 36b and 36c is prevented, thereby preventing damage to the spring portions 36b and 36c and thus greatly increasing lifespan of the fingers.

As is apparent from the above description, in the feeding belt according to the present invention, each of the angle displacement hinge parts 36, which open and close the respective gripping parts 38, includes the spring portion 36a directly connected to the support fixing part 34, the spring portion 36c directly connected to the gripping part 38, and the intermediate spring portion 36b between the spring portion 36a directly connected to the support fixing part 34 and the spring portion 36c directly connected to the gripping part 38, and each of the angle displacement hinge parts 36 is configured so that the diameter of the spring portion 36a directly connected to the support fixing part 34 is greater than that of the intermediate spring portion 36b or the spring portion 36c directly connected to the gripping part 38, or each of the angle displacement hinge parts 36 is configured to have an eccentric structure in which the centers 36ao, 36bo and 36co of the spring portions 36a, 36b and 36c do not coincide with each other or is configured to have a concentric structure in which the centers 36ao, 36bo and 36co of the spring portions 36a, 36b and 36c coincide with each other. During operation, therefore, force is balanced and uniformly distributed by the action of the spring of each of the angle displacement hinge parts 36, thereby achieving smoother operation. Consequently, it is possible to prevent the occurrence of a fatigue fracture phenomenon and to prevent damage to the angle displacement hinge parts 36 due to friction between the angle displacement hinge parts 36 and the belt main body 20 during operation, thereby greatly increasing lifespan of the fingers. Also, the support fixing parts 34, by which the fingers 30 are elastically mounted to the belt main body 20 when the fingers 30 are coupled to the belt main body 20, and the angle displacement hinge parts 36 to serve as hinges, by which angles of the gripping parts 38 of the fingers 30 are changed, and, in addition, to generate elastic gripping force to grip the gripping parts 38 are independently operated. Also, the gripping parts 38 are pushed by external force so that the gripping parts 38 are opened or closed in the forward direction in which the spring of each of the angle displacement hinge parts 36 is wound, not in the reverse direction in which the spring of each of the angle displacement hinge parts 36 is unwound, thereby achieving smooth and secure operation while exhibiting high durability.

Although the preferred embodiments of the present invention have been disclosed for illustrative purposes, those skilled in the art will appreciate that various modifications, additions and substitutions are possible, without departing from the scope and spirit of the invention as disclosed in the accompanying claims.

## Claims

1. A feeding belt used to feed strip-shaped elements in an automated inline process, such as a plating process or a deflashing process, during mass production of semiconductors or other products, the feeding belt being configured so that a plurality of separately manufactured fingers is coupled to a belt main body in a predetermined pitch interval, wherein
the belt main body includes mount holes, into which mount parts and support fixing parts of the respective fingers are coupled, and long holes provided below the respective mount holes so that gripping parts of the respective fingers are movably fitted in the long holes,
each of the fingers includes a mount part provided at one end thereof, a support fixing part provided adjacent to the mount part, the support fixing part being configured so that a portion of the support fixing part is coupled into a corresponding one of the mount holes of the belt main body to elastically support the belt main body and each of the fingers, a coupling part provided between the mount part and the support fixing part so that the coupling part is fitted in a corresponding one of the mount holes of the belt main body, an angle displacement hinge part provided adjacent to the support fixing part to transmit elastic gripping force to a corresponding one of the gripping parts and to serve as a hinge, the angle displacement hinge part being formed in the shape of a coil spring, and a gripping part provided adjacent to the angle displacement hinge part, the gripping part being bent at the other end thereof, the gripping part being fitted in a corresponding one of the long holes of the belt main body, the mount part, the coupling part, the support fixing part, the angle displacement hinge part, and the gripping part being integrally connected to each other,
the angle displacement hinge part includes a spring portion directly connected to the support fixing part, a spring portion directly connected to the gripping part, and an intermediate spring portion between the spring portion directly connected to the support fixing part and the spring portion directly connected to the gripping part, the spring portion directly connected to the support fixing part, the intermediate spring portion, and the spring portion directly connected to the gripping part being integrally connected to each other, and
the diameter of the spring portion directly connected to the support fixing part is greater than that of the intermediate spring portion or the spring portion directly connected to the gripping part.

2. The feeding belt for strip-shaped elements according to claim 1, wherein the angle displacement hinge part is configured so that the diameter of the intermediate spring portion is greater than that of the spring portion directly connected to the gripping part.

3. The feeding belt for strip-shaped elements according to claim 1, wherein the angle displacement hinge part is configured so that the diameter of the intermediate spring portion is equal to that of the spring portion directly connected to the gripping part.

4. The feeding belt for strip-shaped elements according to claim 1, wherein the angle displacement hinge part is configured so that the diameter of the intermediate spring portion is less than that of the spring portion directly connected to the gripping part.

5. The feeding belt for strip-shaped elements according to claim 1, wherein the angle displacement hinge part of each of the fingers is configured to have a concentric structure in which the center of the spring portion directly connected to the support fixing part, the center of the intermediate spring portion, and the center of the spring portion directly connected to the gripping part coincide with each other.

6. The feeding belt for strip-shaped elements according to claim 1, wherein the angle displacement hinge part of each of the fingers is configured to have an eccentric structure in which the center of the spring portion directly connected to the support fixing part, the center of the intermediate spring portion, and the center of the spring portion directly connected to the gripping part do not coincide with each other.

7. The feeding belt for strip-shaped elements according to claim 1, wherein each of the fingers is formed of a wire, the mount part, the support fixing part, the angle displacement hinge part, and the gripping part being integrally formed, and
the support fixing part is wound in the direction opposite to the direction in which the angle displacement hinge part is wound.

8. The feeding belt for strip-shaped elements according to claim 1, wherein each of the fingers is formed of a wire, the mount part, the support fixing part, the angle displacement hinge part, and the gripping part being integrally formed,
the support fixing part is formed in the shape of a bent coupling part, and
the angle displacement hinge part is formed in the shape of a coil spring.

9. The feeding belt for strip-shaped elements according to claim 1, wherein
the mount part, the support fixing part, the angle displacement hinge part, and the gripping part of each of the fingers are integrally formed, and
an additional bent part is provided between the angle displacement hinge part and the gripping part to easily perform a pushing operation in the horizontal direction.
